# EUROPEAN PATENT APPLICATION

(11) **EP 1 985 643 A1**
(43) Date of publication of application: **29.10.2008**
(21) Application number: 07714131.5
(22) Date of filing: 14.02.2007
(51) Int. Cl.: C08G 61/12, C09K 11/06, H01L 51/50, H05B 33/10

(54) **POLYMERIC COMPOUND FOR ORGANIC ELECTROLUMINESCENCE AND METHOD FOR PRODUCTION THEREOF**

(30) Priority: 15.02.2006 JP 2006037511
(71) Applicant: Idemitsu Kosan Co., Ltd., Chiyoda-ku Tokyo 100-8321 (JP)
(72) Inventor: INOUE, Tetsuya, Sodegaura-shi, Chiba 299-0293 (JP); KONDO, Hirofumi, Sodegaura-shi, Chiba 299-0293 (JP)
(74) Representative: Gille Hrabal Struck Neidlein Prop Roos
(86) International application number: PCT/JP2007/052553
(87) International publication number: WO 2007/094331

(57) **Abstract**

A polymer compound for an organic electroluminescence device, which has a halogen element content of 50 ppm by mass or less.

## Description

### TECHNICAL FIELD

The invention relates to a polymer compound useful as a material for an organic electroluminescence device and a production method thereof, particularly a polymer compound with a reduced halogen element content and a production method thereof.

### BACKGROUND

An organic electroluminescence device (hereinafter occasionally abbreviated as organic EL device) is a light-emitting device having at least an organic emitting layer held between a pair of electrodes. The device emits light derived from energy generated by re-combining holes injected from an anode with electrons injected from a cathode in the organic emitting layer.

The organic EL device is a self-emission device and has various advantageous properties such as highly efficient emission, low cost, light weight and compact size. Thus, the organic EL device have recently been studied and developed actively. It is known as a problem of the organic EL device that the luminance decreases with an increase in driving time. Various improvements are attempted to suppress this luminance deterioration.

For example, it is disclosed that the luminance deterioration of an organic EL device can be suppressed by controlling the halogen impurity concentration in an organic material used for the organic EL device to be less than 1000 ppm by mass (see Patent Document 1, for example).
For the method of controlling an aromatic compound used in an organic EL device to have a desired halogen impurity concentration, the above patent document discloses combinations of purifying techniques such as sublimation and recrystallization. However, techniques for controlling a halogen impurity amount to an even higher degree are recently demanded. The development of production techniques which enable the halogen element content of a material for an organic EL device to be further reduced is needed.

Materials for an organic EL device are generally produced by synthesis methods such as the Ullman reaction, Grignard reaction and Suzuki coupling reaction using an aromatic halide as an intermediate. It is known that the performance (luminance deterioration and initial efficiency) of an organic EL device is significantly influenced by impurities contained in materials used therein. Thus the materials are generally purified by methods such as sublimation, column purification and recrysitallization which uses differences in properties therebetween.

Regarding the high purification of a material for an organic EL device, it is important to reduce halide impurities in the material for an organic EL device, particularly high-reactive bromides and iodides. However, bromides and iodides cannot be sufficiently reduced by conventional methods.
Further, among various materials for an organic EL device, polymer compounds, unlike low-molecular materials, cannot be purified by sublimation, silica gel column and recrystallization. Thus, an organic EL device using a polymer compound has a shorter life and less practicality, compared to an organic EL device using a low-molecular material.
The polymer compound is generally dissolved in an organic solvent and a film is formed from the solution by spin coating, ink jet and the like, thereby fabricating an organic EL device. Since the organic solvent used can contain halogen, the concentration of halogen contained in the polymer compound is required to be sufficiently reduced. Patent Document 1: WO00/41443 pamphlet

### SUMMARY OF THE INVENTION

An object of the invention is to provide a polymer compound for an organic EL device with a reduced content of halogen elements contained in the polymer compound and a production method thereof.

The invention provides the following polymer compound for an organic EL device and the like.
1. A polymer compound for an organic electroluminescence device, which has a halogen element content of 50 ppm by mass or less.
2. The polymer compound for an organic ELECTROLUMINESCENCE device according to 1, which is obtained by polymerizing a halogen-containing monomer.
3. The polymer compound for an organic ELECTROLUMINESCENCE device according to 1 or 2, wherein the halogen is iodine or bromine.
4. A polymer compound, which has a halogen element content of 50 ppm by mass or less and contains a structure of formula (1), 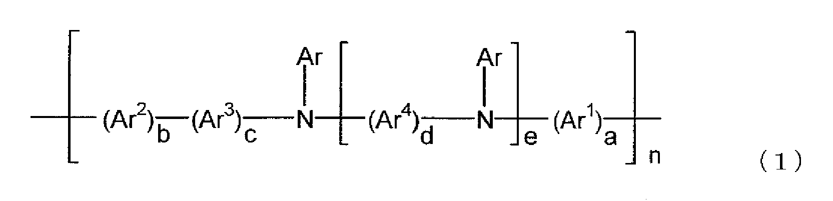
   wherein Ars are each a substituted or non-substituted aryl group having 6 to 40 carbon atoms or a substituted or non-substituted heteroaryl group having 3 to 40 carbon atoms,
   Ar¹ to Ar⁴ are each a substituted or non-substituted divalent arylene group having 6 to 40 carbon atoms,
   a, b, c and d are each an integer of 1 to 2,
   e is an integer of 0 to 2, and
   n is an integer of 3 or more.
5. The polymer compound according to 4, wherein the polymer compound of formula (1) is represented by formulas (a) to (k), 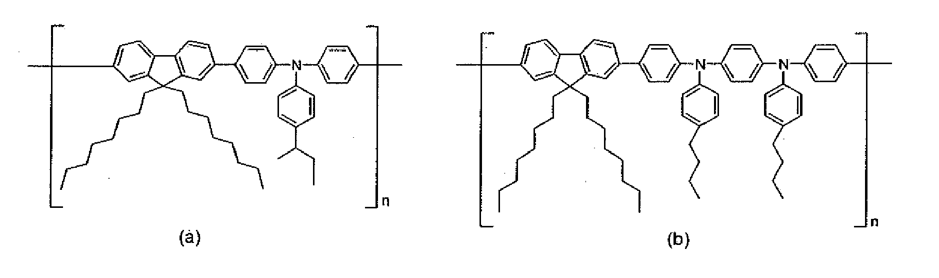 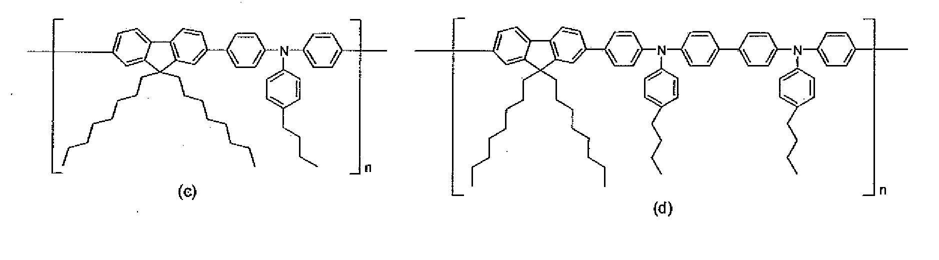 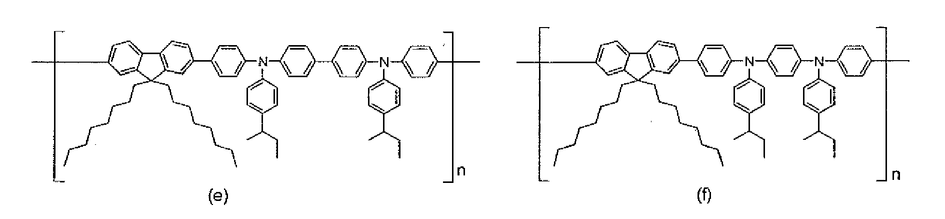 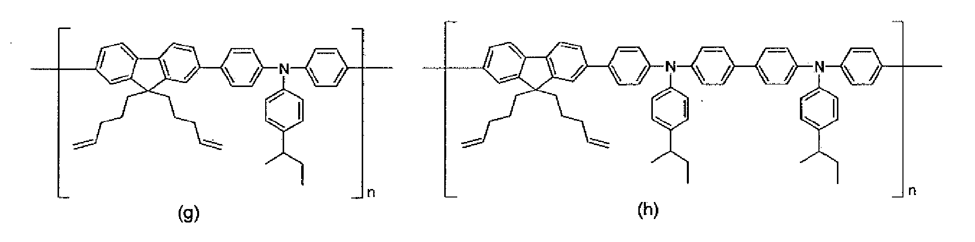 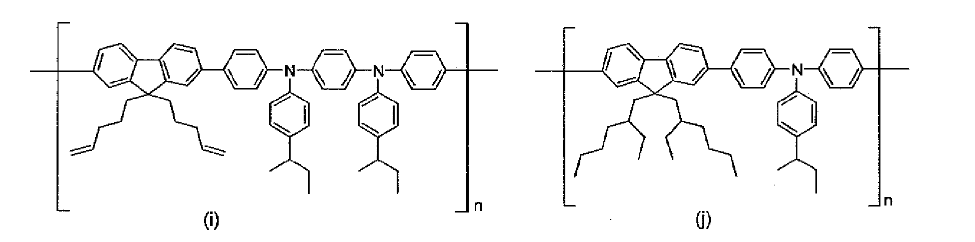 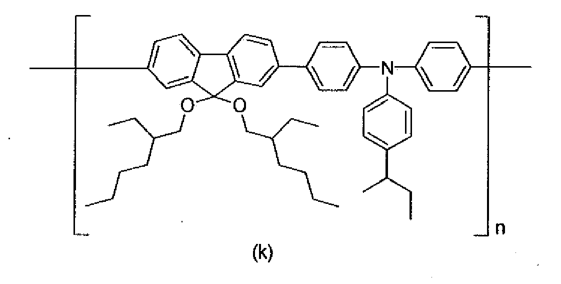 wherein n is a repeat number.
6. The polymer compound according to 5, wherein the polymer compound of formula (1) is represented by formula (a).
7. The polymer compound according to any one of 4 to 6, which is used in a hole-transporting layer and/or a hole-injecting layer of an organic electroluminescence device.
8. A method for producing a polymer compound for an organic electroluminescence device comprising;
   synthesizing a polymer compound with a halogen element content of 500 ppm by mass or more, using a halogen-containing monomer; and
   treating the polymer compound with a dehalogenating agent.
9. The method for producing a polymer compound for an organic electroluminescence device according to 8, wherein the dehalogenating agent is at least one selected form a Grignard reagent, an organic lithium compound and a boronic acid derivative.
10. The method for producing a polymer compound for an organic electroluminescence device according to 9, wherein the Grignard reagent is at least one selected from phenyl magnesium bromide, phenyl magnesium iodine, ethyl magnesium bromide and ethyl magnesium iodide.
11. The method for producing a polymer compound for an organic electroluminescence device according to 9, wherein the organic lithium compound is at least one selected from n-butyl lithium and phenyl lithium.
12. The method for producing a polymer compound for an organic electroluminescence device according to 9, wherein the boronic acid derivative is phenyl boronic acid or analogs thereof.
13. An organic electroluminescence device comprising the polymer compound according to any one of 1 to 6.

The invention can provide a polymer compound for an organic EL device with a reduced content of halogen contained in the polymer compound and a production method thereof.
Further, the use of the polymer compound for an organic EL device of the invention improves the life of the resultant organic EL device.

### BEST MODE FOR CARRYING OUT THE INVENTION

The polymer compound for an organic EL device of the invention has a halogen element content of 50 ppm by mass or less.
The halogen element content of 50 ppm by mass or less enables the life of an organic EL device to be lengthened.
The halogen element content is preferably 20 ppm by mass or less.
The halogen element content of the polymer compound is measured by ICP-MS (combustion method).

The polymer compound for an organic EL device of the invention particularly relates to a polymer compound obtained by polymerizing a halogen-containing monomer.
The polymer compound of the invention is preferably a polymer compound of formula (1).

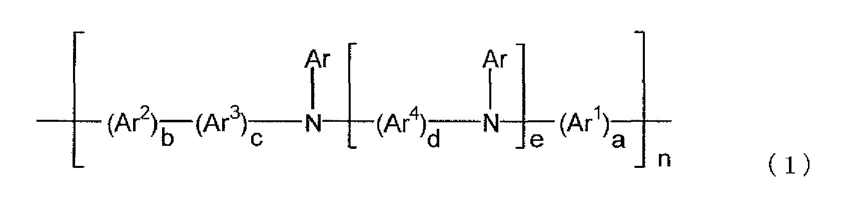

In formula (1), Ars are each a substituted or non-substituted aryl group having 6 to 40 carbon atoms or a substituted or non-substituted heteroaryl group having 3 to 40 carbon atoms,
Ar¹ to Ar⁴ are each a substituted or non-substituted divalent arylene group having 6 to 40 carbon atoms,
a, b, c and d are each an integer of 1 to 2,
e is an integer of 0 to 2, and
n is an integer of 3 or more.

The polymer compound of formula (1) can be used in a hole-transporting layer and/or a hole-injecting layer.

In formula (1), examples of the aryl group having 6 to 40 ring carbon atoms of Ar include a phenyl group, 2-biphenylyl group, 3-biphenylyl group, 4-biphenylyl group, terphenyl group, 3,5-diphenylphenyl group, 3,5-d(1-naphthyl)phenyl group, 3,5-di(2-naphthyl)phenyl group, 3,4-diphenylphenyl group, pentaphenylphenyl group, 4-(2,2-diphenylvinyl)phenyl group, 4-(1,2,2-triphenylvinyl)phenyl group, fluorenyl group, 1-naphthyl group, 2-naphthyl group, 4-(1-naphthyl)phenyl group, 4-(2-naphthyl)phenyl group, 3-(1-naphthyl)phenyl group, 3-(2-naphthyl)phenyl group, 9-anthryl group, 2-anthryl group, 9-phenanthryl group, 1-pyrenyl group, chrysenyl group, naphthacenyl group, cholonyl group, and spirobifluorenyl group.

Examples of the heteroaryl group having 3 to 40 ring carbon atoms include a 1-pyrrolyl group, 2-pyrrolyl group, 3-pyrrolyl group, pyrazinyl group, primidyl group, pridazyl group, 2-pyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiadinyl group, 2-phenothiadinyl group, 3-phenothiadinyl group, 4-phenothiadinyl group, 10-phenothiadinyl group, 1-phenoxadinyl group, 2-phenoxadinyl group, 3-phenoxadinyl group, 4-phenoxadinyl group, 10-phenoxadinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butyl-pyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, and 4-t-butyl-3-indolyl group.

In formula (1), examples of the substituted or non-substituted C6 to C40 divalent arylene group of Ar¹ to Ar⁴ include ones obtained by removing a hydrogen atom from the above-mentioned examples of aryl group of Ar having 6 to 40 carbon atoms that form a ring.

In formula (1), the substituents of aryl, arylene and heteroaryl groups of Ar and Ar¹ to Ar⁴ include an alkyl group (preferably 1 to 20 carbon atoms, more preferably 1 to 12 carbon atoms, particularly preferably 1 to 8 carbon atoms; for example, methyl, ethyl, isopropyl, t-butyl, n-octyl, n-decyl, n-hexadecyl, cyclopropyl, cyclopentyl, and cyclohexyl), alkenyl group (preferably 2 to 20 carbon atoms, more preferably 2 to 12 carbon atoms, particularly preferably 2 to 8 carbon atoms; for example, vinyl, allyl, 2-butenyl, and 3-pentenyl), alkynyl group (preferably 2 to 20 carbon atoms, more preferably 2 to 12 carbon atoms, particularly preferably 2 to 8 carbon atoms; for example, propargyl, and 3-pentynyl), amino group (preferably 0 to 20 carbon atoms, more preferably 0 to 12 carbon atoms, particularly preferably 0 to 6 carbon atoms; for example, amino, methylamino, dimethylamino, diethylamino, diphenylamino, and dibenzylamino), alkoxy group (preferably 1 to 20 carbon atoms, more preferably 1 to 12 carbon atoms, particularly preferably 1 to 8 carbon atoms; for example, methoxy, ethoxy, and butoxy), aryloxy group (preferably 6 to 20 carbon atoms, more preferably 6 to 16 carbon atoms, particularly preferably 6 to 12 carbon atoms; for example, phenyloxy, and 2-naphthyloxy), acyl group (preferably 1 to 20 carbon atoms, more preferably 1 to 16 carbon atoms, particularly preferably 1 to 12 carbon atoms; for example, acetyl, benzoyl, formyl, and pivaloyl), alkoxycarbonyl group (preferably 2 to 20 carbon atoms, more preferably 2 to 16 carbon atoms, particularly preferably 2 to 12 carbon atoms; for example, methoxycarbonyl, and ethoxycarbonyl), aryloxycarbonyl group (preferably 7 to 20 carbon atoms, more preferably 7 to 16 carbon atoms, particularly preferably 7 to 10 carbon atoms; for example, phenyloxycarbonyl), acyloxy group (preferably 2 to 20 carbon atoms, more preferably 2 to 16 carbon atoms, particularly preferably 2 to 10 carbon atoms; for example, acetoxy, and benzoyloxy), acylamino group (preferably 2 to 20 carbon atoms, more preferably 2 to 16 carbon atoms, particularly preferably 2 to 10 carbon atoms; for example, acetylamino, and benzoylamino), alkoxycarbonylamino group (preferably 2 to 20 carbon atoms, more preferably 2 to 16 carbon atoms, particularly preferably 2 to 12 carbon atoms; for example, methoxycarbonylamino), aryloxycarbonylamino group (preferably 7 to 20 carbon atoms, more preferably 7 to 16 carbon atoms, particularly preferably 7 to 12 carbon atoms; for example, phenyloxycarbonylamino), sulfonylamino group (preferably 1 to 20 carbon atoms, more preferably 1 to 16 carbon atoms, particularly preferably 1 to 12 carbon atoms; for example, methanesulfonylamino, and benzenesulfonylamino), sulfamoyl group (preferably 0 to 20 carbon atoms, more preferably 0 to 16 carbon atoms, particularly preferably 0 to 12 carbon atoms; for example, sulfamoyl, methylsulfamoyl, dimethylsulfamoyl, and phenylsulfamoyl), carbamoyl group (preferably 1 to 20 carbon atoms, more preferably 1 to 16 carbon atoms, particularly preferably 1 to 12 carbon atoms; for example, carbamoyl, methylcarbamoyl, diethylcarbamoyl, and phenylcarbamoyl), alkylthio group (preferably 1 to 20 carbon atoms, more preferably 1 to 16 carbon atoms, particularly preferably 1 to 12 carbon atoms; for example, methylthio, and ethylthio), arylthio group (preferably 6 to 20 carbon atoms, more preferably 6 to 16 carbon atoms, particularly preferably 6 to 12 carbon atoms; for example, phenylthio), sulfonyl group (preferably 1 to 20 carbon atoms, more preferably 1 to 16 carbon atoms, particularly preferably 1 to 12 carbon atoms; for example, mesyl and tosyl), sulfinyl group (preferably 1 to 20 carbon atoms, more preferably 1 to 16 carbon atoms, particularly preferably 1 to 12 carbon atoms; for example, methanesulfinyl, and benzenesulfinyl), ureide group (preferably 1 to 20 carbon atoms, more preferably 1 to 16 carbon atoms, particularly preferably 1 to 12 carbon atoms; for example, ureide, methylureide, and phenylureide), amide phosphate group (preferably 1 to 20 carbon atoms, more preferably 1 to 16 carbon atoms, particularly preferably 1 to 12 carbon atoms; for example, diethyl amide phosphate, and phenyl amide phosphate), hydroxy group, mercapto group, halogen atom (for example, fluorine atom, chlorine atom, bromine atom, and iodine atom), cyano group, sulfo group, carboxyl group, nitro group, hydroxamic acid group, sulfino group, hydrazino group, imino group, heterocyclic group (preferably 1 to 30 carbon atoms, more preferably 1 to 12 carbon atoms; for example, groups containing a hetero atom such as nitrogen atom, oxygen atom and sulfur atom; specifically, for example, imidazolyl, pyridyl, quinolyl, furyl, thenyl, piperidyl, morpholino, benzoxazolyl, benzoimidazolyl, benzothiazolyl, and carbazolyl), and silyl group (preferably 3 to 40 carbon atoms, more preferably 3 to 30 carbon atoms, particularly preferably 3 to 24 carbon atoms; for example, trimethylsilyl, and triphenylsilyl). These substituents may be substituted. If there are two or more substituents, they may be the same or different. If possible, they may join to form a ring.

Preferred examples of the polyarylamine of formula (1) are shown below, but the polyarylamine is not limited thereto. 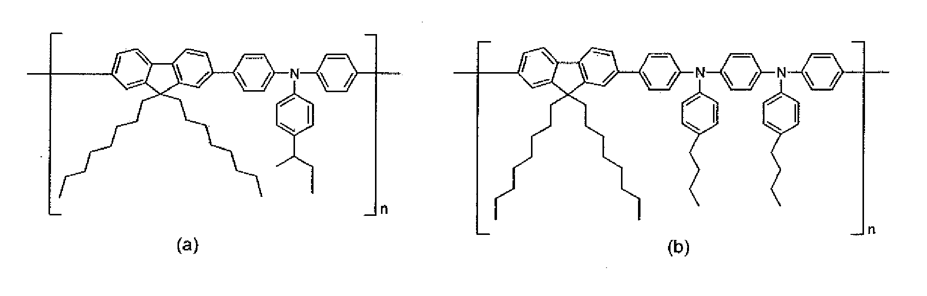 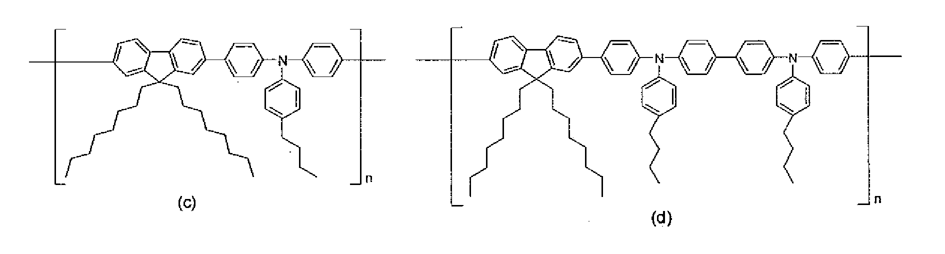 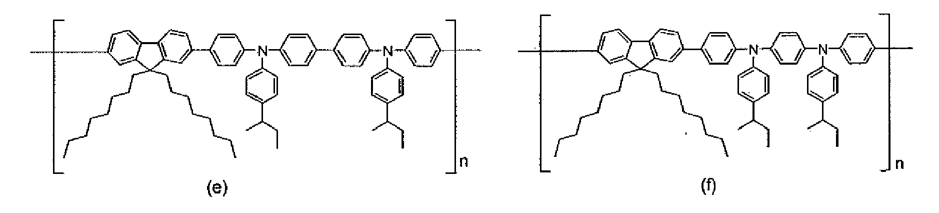 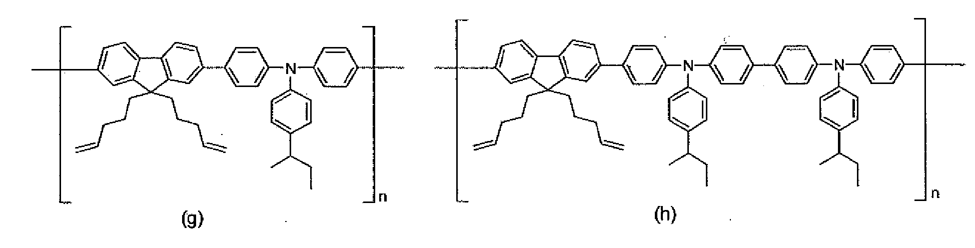 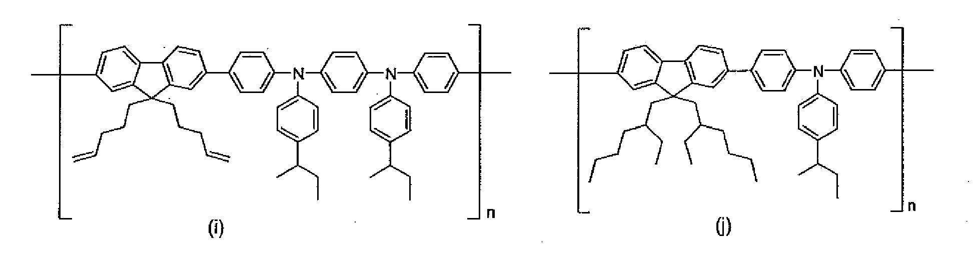 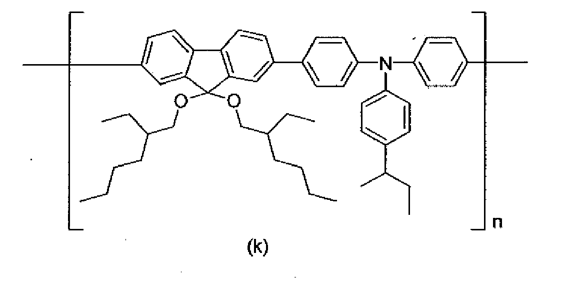 In the formula, n is a repeat number.

As an example of the polymer compound of the invention, the following polymer compounds can also be given. 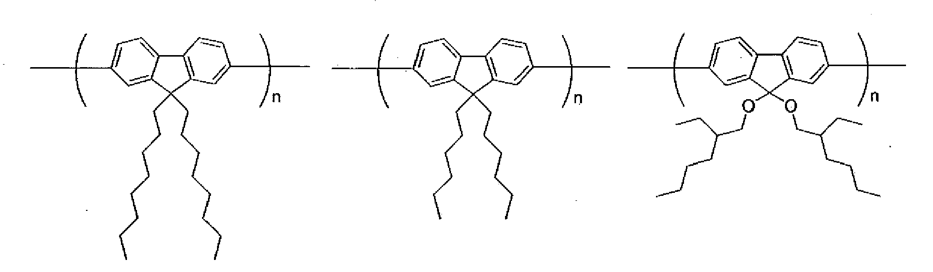 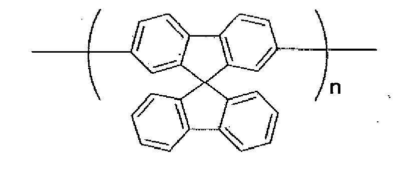 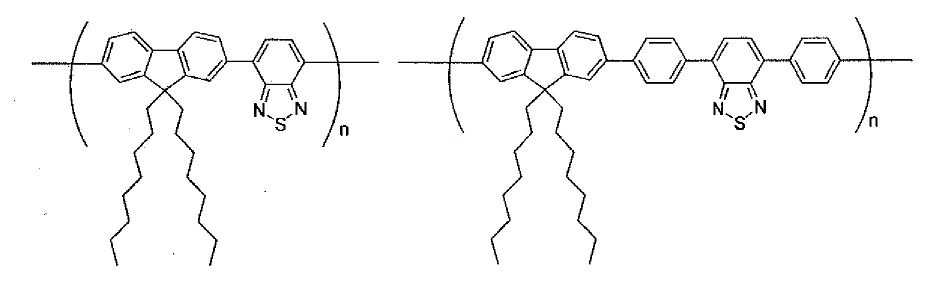 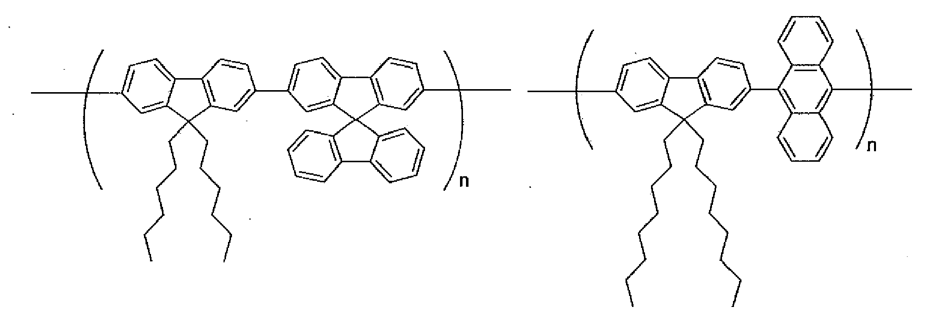 In the formula, n is a repeat number.

The polymer compound of the invention can be produced by the steps of synthesizing a polymer compound using a halogen-containing monomer, and treating the polymer compound with a dehalogenating agent.
After the step of synthesizing a polymer compound, the halogen element content of the polymer compound is 500 ppm by mass or more. However, by treating the polymer compound with a dehalogenating agent, a highly pure polymer compound for an organic EL device with a halogen element content of 50 ppm by mass or less can be produced.

The polymer compound of the invention is a polymer compound synthesized by using at least one selected from compounds of formulas (2) to (4).

X-Ar⁵-X (2) 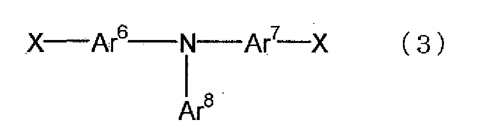 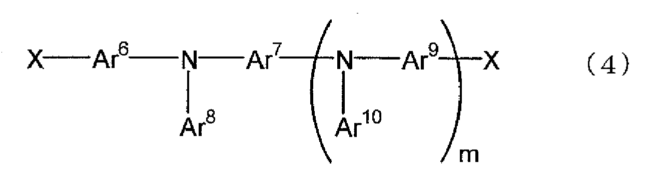 wherein Ar⁵, Ar⁶, Ar⁷ and Ar⁹ are each a substituted or non-substituted divalent arylene group having 6 to 40 carbon atoms or heteroarylene group having 3 to 40 carbon atoms, Ar⁸ and Ar¹⁰ are each a substituted or non-substituted aryl group having 6 to 40 carbon atoms or heteroaryl group having 3 to 40 carbon atoms, X is bromine or iodine, and m is an integer of 1 to 3.

In formulas (2) to (4), the substituted or non-substituted C6 to C40 divalent arylene group of Ar⁵, Ar⁶, Ar⁷ and Ar⁹ are similar to that of Ar³ and Ar⁴ in formula (1).

In formulas (2) to (4), the substituted or non-substituted C6 to C40 aryl group and C3 to C40 heteroaryl group of Ar⁸ and Ar¹⁰ are similar to those of Ar in formula (1).

The polymer compound of the invention may be a polymer compound obtained by polymerizing a compound of formula (5) with at least one selected from compounds of formulas (2) to (4). 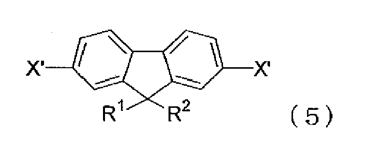 wherein R¹ and R² are each an alkyl group having 1 to 12 carbon atoms, an alkenyl group having 2 to 12 carbon atoms or an alkoxy group having 1 to 12 carbon atoms; R¹ and R² may be bonded to form a ring; and X' is a boronic acid or boronate ester.

In formula (5), the C1 to C12 alkyl group of R¹ and R² includes a methyl, ethyl, n-propyl, isopropyl, n-butyl, t-butyl, n-pentyl, n-hexyl, n-heptyl, 2-ethylhexyl, n-octyl and n-decyl group.
The alkenyl group of R¹ and R² includes a vinyl, allyl, 2-butenyl, 3-pentenyl and 4-pentenyl group.
The C1 to C12 alkoxy group of R¹ and R² includes a methoxy, ethoxy, propoxy, butoxy and 2-ethylhexyl group.
R¹ and R² may be bonded to form a cyclic compound.

In formula (5), X' is a boronic acid or boronate ester, which is shown by -B(OH)₂ and -B(OR')2, respectively. R' includes methyl, ethyl and isopropyl. R's may be bonded to each other to form a cyclic compound.

In the treatment step with a dehalogenating agent, a halogen residue of halogen compounds which are impurities contained in the polymer compound is converted to another substituent by chemical reactions for detoxification.
For the method of converting a halogen residue to another substituent, any reactions known as a dehalogenating reaction may be used. Of these, the Grignard reaction, a reaction using an organic lithium compound and a reaction using a boronic acid derivative (Suzuki coupling reaction) are particularly preferred due to their high yields.

The Grignard reaction is a coupling reaction of a halogen residue and a Grignard reagent.
As the Grignard reagent, commercially available reagents, aryl magnesium bromide, aryl magnesium iodine, alkyl magnesium bromide and alkyl magnesium iodide, which are prepared when necessary, can be used. Of these, phenyl magnesium bromide, phenyl magnesium iodine, ethyl magnesium bromide and ethyl magnesium iodide are preferred.
Particularly preferred are phenyl magnesium bromide and phenyl magnesium iodine.
The Grignard reagents may be used alone or in combinations of two or more.

Usual solvents may be used as a reaction solvent. Specifically, ether solvents such as dimethoxyethane and tetrahydrofuran are particularly preferred. Mixed solvents thereof may also be used. The reaction solvent is preferably dehydrated.
The reaction temperature may be generally selected from -30 to 100°C, preferably -10 to 80°C. The reaction time may be generally selected from 1 to 48 hours, preferably 2 to 8 hours. The reaction is preferably conducted in an argon flow.

The reaction using an organic lithium (Li) compound is specifically a coupling reaction of a halogen residue and organic lithium reagent.
Various commercially available reagents can be used as the organic lithium compound. Preferred are an aryl lithium and alkyl lithium. Particularly preferred are n-butyl lithium and phenyl lithium.
The organic lithium compounds may be used alone or in combination of two or more.

Usual solvents may be used as the reaction solvent. Preferred are cyclic hydrocarbon solvents such as cyclohexane and decalin and ether solvents such as dimethoxy ethane and tetrahydrofuran. Mixed solvents thereof may also be used.
The reaction temperature may be generally selected from -100 to 50°C, preferably -80 to 10°C. The reaction time may be generally selected from 1 to 48 hours, preferably 1 to 8 hours. The reaction is preferably conducted in a nitrogen or argon flow.

The reaction using a boronic acid derivative, which is called a Suzuki coupling reaction, is a coupling reaction of a halogen residue and boronic acid derivatives.
Various commercially available boronic acids can be used as the boronic acid derivative. Preferred are phenyl boronic acid and derivatives thereof. The boronic acid derivatives may be used alone or in combination of two or more.

Reasons why the Suzuki coupling reaction is preferred include not only that it shows a high reactivity with halogen but also that, if a material containing a substituent such as nitro and methoxy is subjected to the dehalogenating treatment, these substituents are not reacted.
Usual solvents may be used as the reaction solvent. Specifically, the solvent includes aromatic hydrocarbon solvents such as toluene and xylene, cyclic hydrocarbon solvents such as cyclohexane and decalin and ether solvents such as dimethoxyethane and tetrahydrofuran.
Of these, particularly preferred are aromatic hydrocarbon solvents such as toluene and xylene, and ether solvents such as dimethoxyethane and tetrahydrofuran.
Mixed solvents thereof may also be used.

The reaction is preferably conducted in a suspension state while stirring a two-layered solvent of these solvents and water. A base is usually used in this reaction. The base includes carbonates, phosphates and hydroxides of alkali metals and alkali earth metals. potassium carbonate, cesium carbonate and potassium phosphate are preferred.
In this reaction, a transition metal complex such as Pd and Ni can be generally used as a catalyst.
Specifically, Pd(PPh₃)₄ and palladium acetate are preferred. The transition metal complex such as Pd and Ni may be used with a phosphorus ligand. For example, tris(o-tryl)phosphine, tri(t-butyl)phosphine, e.t.c. are preferably used as a ligand.
The reaction temperature may be generally selected from 50 to 200°C, preferably 70 to 150°C. The reaction time may be generally selected from 4 to 48 hours, preferably 8 to 16 hours. The reaction is preferably conducted in a nitrogen or argon flow.

In the production of the polymer compound, a crude polymer compound (crude product) contains 500 ppm by mass or more of a halogen element, but the halogen element content can be significantly reduced by the above-mentioned chemical reaction treatment.
If the crude product is purified by an ordinary method, a polymer compound with a reduced halogen element content of 100 ppm by mass or less can be obtained. The halogen impurity concentration of such a polymer compound can be further reduced by the above chemical reaction treatment.
The dehalogenating treatment allows the halogen element content in a polymer compound to be reduced to 50 ppm by mass or less.

### [Examples]

### Synthesis Example 1

A polymer compound of formula (a) was synthesized by the following method.

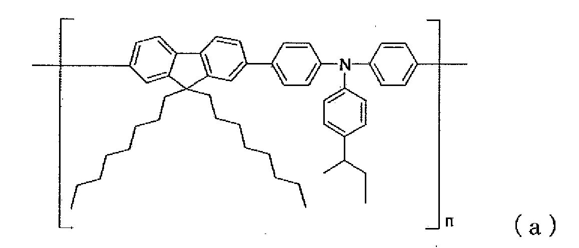

In an argon atmosphere, 9,9-dioctylfluoren-2,7-bis(trimethyleneborate) (3.6g, 6.6 mmol), 4-sec-butylphenyl-di(4'-bromophenyl)amine (3.0g, 6.6 mmol) and Pd(PPh₃)₄ (24 mg, 2 µmol) were dissolved in anhydrous THF/toluene (30 mL/30 mL), 20 wt% Et₄NOH (18 mL) was added and the mixture was stirred for two hours. Bromobenzene (0.6g) was added to the resultant reaction solution and stirred for 1 hour. Phenylboronic acid (0.6g) was further added and stirred for 1 hour.
The reaction solution was slowly dripped to methanol (1L). A precipitated solid was filtered to obtain 3.3g of a polymer compound of formula (a). The polymer compound had a number average molecular weight of 40500 and molecular weight distribution of 3.35. The Br content was measured by ICP-MS (combustion method) and found to be 580 ppm by mass.

### Synthesis Example 2

The polymer compound synthesized in Synthesis Example 1 was dissolved in toluene. The solution was added to methanol. A precipitated solid was filtered. This process was repeated three times to purify the polymer compound. The Br content of polymer compound thus obtained was measured by ICP-MS (combustion method) and found to be 72 ppm by mass.

### Example 1 (Grignard reagent treatment)

In an argon atmosphere, 1g of the polymer compound of formula (a) obtained in Synthesis Example 2 was dissolved in 50 ml of anhydrous tetrahydrofuran and 0.2 ml of a tetrahydrofuran solution of phenyl magnesium bromide (manufactured by Tokyo Kasei Kogyo Co., Ltd.) was gradually added dropwise thereto while cooling on ice, followed by stirring at 50 to 60°C for 30 minutes. Dilute sulfuric acid was added to decompose unreacted materials. An organic layer was separated. After washing the organic layer with an aqueous sodium hydrogen carbonate solution and then with a saturated saline solution, the layer was concentrated under reduced pressure. The concentrated residue was purified by silica gel column chromatography (elution solvent: methylene chloride) to obtain 0.91g of a yellow fibrous solid.
The Br content of polymer compound thus obtained was measured by ICP-MS (combustion method) and found to be 48 ppm by mass.

### Example 2 (Organic lithium reagent treatment)

In an argon atmosphere, 1g of the polymer compound of formula (a) obtained in Synthesis Example 2 was dissolved in 50 ml of anhydrous tetrahydrofuran and 0.2 ml of a 1.6M hexane solution of n-butyl lithium was gradually added dropwise thereto while cooling on ice, followed by stirring at 0°C for 60 minutes. Water was added to the reaction solution to separate an organic layer. After washing the organic layer with a saturated aqueous ammonium chloride solution and then with a saturated saline solution, the layer was concentrated under reduced pressure. The concentrated residue was purified by silica gel column chromatography (elution solvent: methylene chloride) to obtain 0.89g of a yellow fibrous solid.
The Br content of polymer compound thus obtained was measured by ICP-MS (combustion method) and found to be 20 ppm by mass.

### Example 3 (Suzuki coupling reaction treatment)

In an argon atmosphere, 1g of the polymer compound of formula (a) obtained in Synthesis Example 2 was dissolved in 50 ml of anhydrous tetrahydrofuran, and 22 mg of tetrakis(triphenylphosphine)palladium(0), 0.2g of phenyl boronic acid and 3 ml of a 2M aqueous sodium carbonate solution were added, followed by stirring at 80°C for 8 hours. Water was added to separate an organic layer.
After washing the organic layer with a saturated saline solution, the layer was concentrated under reduced pressure. The concentrated residue was purified by silica gel column chromatography (elution solvent: methylene chloride) to obtain 0.90g of a yellow fibrous solid.
The Br content of polymer compound thus obtained was measured by ICP-MS (combustion method) and found to be 15 ppm by mass.

### Example 4

A glass substrate of 25 mm by 75 mm by 1.1 mm thick with an ITO (indium tin oxide) transparent electrode (manufactured by GEOMATEC CO., LTD.) was subjected to ultrasonic cleaning with isopropyl alcohol for 5 minutes, and cleaned with ultraviolet rays and ozone for 30 minutes.
A 40-nm-thick film of polyethylenedioxy thiophene/polystyrene sulfonic acid (PEDOT:PSS) was formed as a hole-injecting layer on the substrate by spin coating. Next, the toluene solution of polymer compound prepared in Example 1 was applied as a hole-transporting layer on the PEDOT:PSS by spin coating to form a 20-nm-thick film.
Compound A of the following formula was deposited to form a film thereon. The film had a thickness of 40 nm. PAVB of the following formula as a luminescent molecule was simultaneously co-deposited at a weight ratio of Compound A:PAVB = 40:2. This film functioned as an emitting layer.
A 10-nm-thick film of tris(8-quinolinol) aluminum (Alq film) was formed thereon. This Alq film functioned as an electron-injecting layer. Then, Li as a reductive dopant (Li source: manufactured by SAES Getters Co., Ltd.) and Alq were co-deposited, whereby an Alq:Li film was formed as an electron-injecting layer (cathode). Metal aluminum was deposited on the Alq:Li film to form a metallic cathode, whereby an organic EL device was fabricated.
Table 1 shows the luminance half life at an initial luminance of 1000 cd/m² of this device.

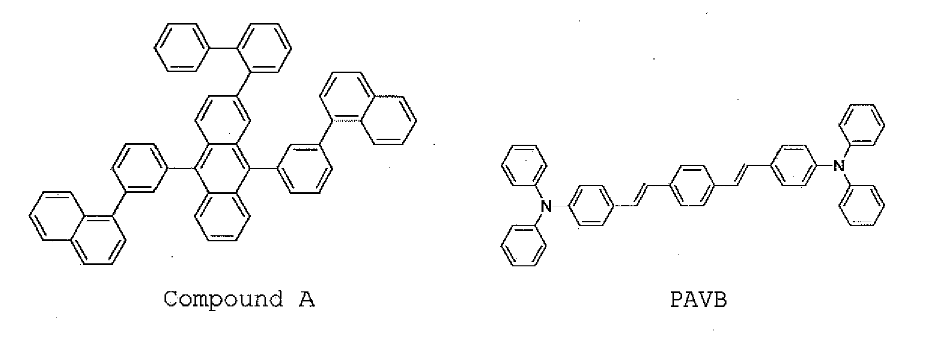

### Example 5

An organic EL device was fabricated in the same manner as in Example 4, except that the polymer compound prepared in Example 2 was used instead of the polymer compound synthesized in Example 1. Table 1 shows the luminance half life at an initial luminance of 1000 cd/m² of this device.

### Example 6

An organic EL device was fabricated in the same manner as in Example 4, except that the polymer compound prepared in Example 3 was used instead of the polymer compound synthesized in Example 1. Table 1 shows the luminance half life at an initial luminance of 1000 cd/m² of this device.

### Comparative Example 1

An organic EL device was fabricated in the same manner as in Example 4, except that the polymer compound of formula (a) prepared in Synthesis Example 1 was used instead of the polymer compound prepared in Example 1. Table 1 shows the luminance half life at an initial luminance of 1000 cd/m² of this device.

### Comparative Example 2

An organic EL device was fabricated in the same manner as in Example 4, except that the polymer compound of formula (a) prepared in Synthesis Example 2 was used instead of the polymer compound prepared in Example 1. Table 1 shows the luminance half life at an initial luminance of 1000 cd/m² of this device.

**Table 1**

| | Br content | Luminance |
|---|---|---|
| | (ppm by mass) | Half Life (h) |
| Example 4 | 48 | 1060 |
| Example 5 | 20 | 1100 |
| Example 6 | 15 | 1200 |
| Comparative Example 1 | 580 | 420 |
| Comparative Example 2 | 72 | 700 |

The above results reveal that the use of the polymer compound subjected to the halogenating treatment by chemical reaction in an organic EL device significantly improved the luminance half life of the device.

### Industrial Applicability

The polymer compound of the invention is suitable as a material for organic EL devices, organic semiconductors, electrophotographic photoreceptor, e.t.c.

## Claims

1. A polymer compound for an organic electroluminescence device, which has a halogen element content of 50 ppm by mass or less.

2. The polymer compound for an organic ELECTROLUMINESCENCE device according to claim 1, which is obtained by polymerizing a halogen-containing monomer.

3. The polymer compound for an organic ELECTROLUMINESCENCE device according to claim 1 or 2, wherein the halogen is iodine or bromine.

4. A polymer compound, which has a halogen element content of 50 ppm by mass or less and contains a structure of formula (1), 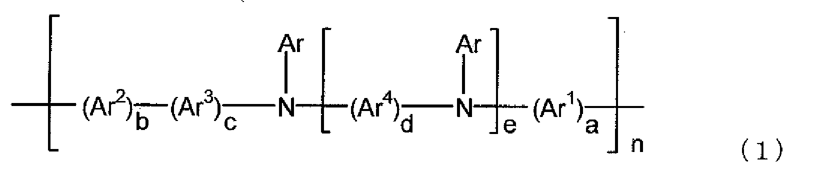
wherein Ars are each a substituted or non-substituted aryl group having 6 to 40 carbon atoms or a substituted or non-substituted heteroaryl group having 3 to 40 carbon atoms,
Ar¹ to Ar⁴ are each a substituted or non-substituted divalent arylene group having 6 to 40 carbon atoms,
a, b, c and d are each an integer of 1 to 2,
e is an integer of 0 to 2, and
n is an integer of 3 or more.

5. The polymer compound according to claim 4, wherein the polymer compound of formula (1) is represented by formulas (a) to (k), 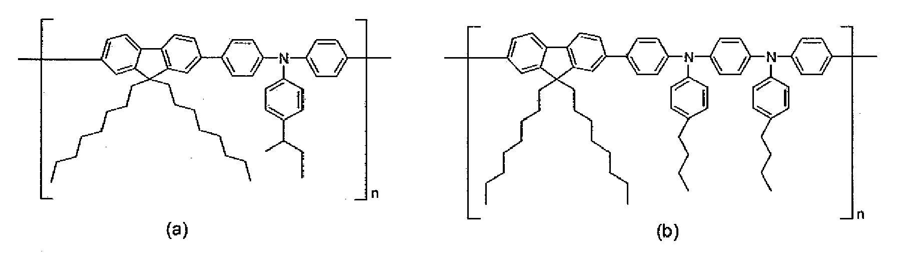 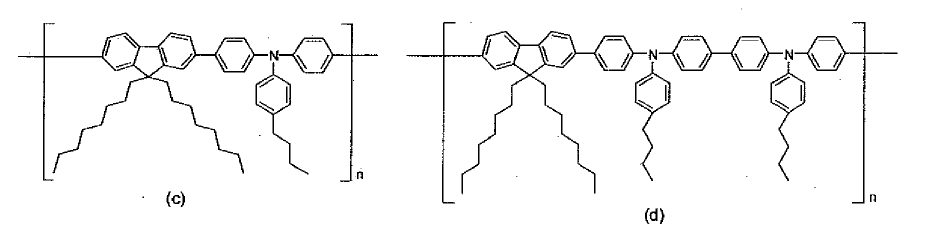 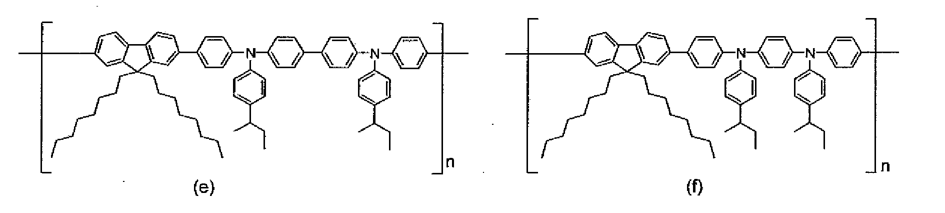 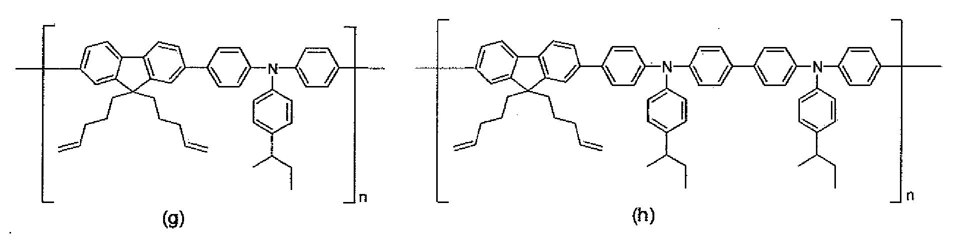 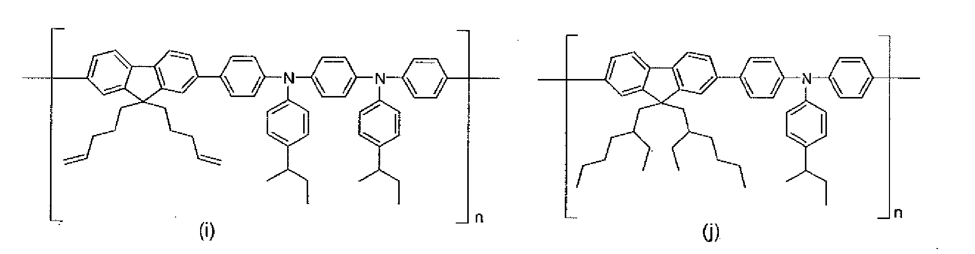 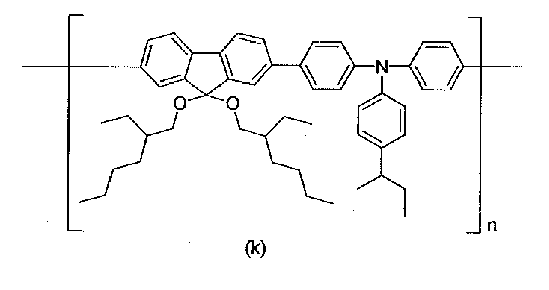 wherein n is a repeat number.

6. The polymer compound according to claim 5, wherein the polymer compound of formula (1) is represented by formula (a).

7. The polymer compound according to any one of claims 4 to 6, which is used in a hole-transporting layer and/or a hole-injecting layer of an organic electroluminescence device.

8. A method for producing a polymer compound for an organic electroluminescence device comprising;
synthesizing a polymer compound with a halogen element content of 500 ppm by mass or more, using a halogen-containing monomer; and
treating the polymer compound with a dehalogenating agent.

9. The method for producing a polymer compound for an organic electroluminescence device according to claim 8, wherein the dehalogenating agent is at least one selected form a Grignard reagent, an organic lithium compound and a boronic acid derivative.

10. The method for producing a polymer compound for an organic electroluminescence device according to claim 9, wherein the Grignard reagent is at least one selected from phenyl magnesium bromide, phenyl magnesium iodine, ethyl magnesium bromide and ethyl magnesium iodide.

11. The method for producing a polymer compound for an organic electroluminescence device according to claim 9, wherein the organic lithium compound is at least one selected from n-butyl lithium and phenyl lithium.

12. The method for producing a polymer compound for an organic electroluminescence device according to claim 9, wherein the boronic acid derivative is phenyl boronic acid or analogs thereof.

13. An organic electroluminescence device comprising the polymer compound according to any one of claims 1 to 6.
